# EUROPÄISCHE PATENTSCHRIFT

(11) **EP 0 715 406 B1**
(45) Veröffentlichungstag und Bekanntmachung des Hinweises auf die Patenterteilung: **01.03.2000**
(21) Anmeldenummer: 95118635.2
(22) Anmeldetag: 27.11.1995
(51) Int. Cl.: H03H 17/04, H03H 11/04

(54) **Abstimmbares elektronisches Filter**
Tunable electronic filter
Filtre électronique accordable

(30) Priorität: 29.11.1994 DE 4442467
(43) Veröffentlichungstag der Anmeldung: 05.06.1996
(73) Patentinhaber: SIEMENS AKTIENGESELLSCHAFT, 80333 München (DE)
(72) Erfinder: Feldtkeller, Martin, Dipl.-Ing., D-81543 München (DE)

(56) Entgegenhaltungen:
- EP-A- 0 467 653
- IEEE JOURNAL OF SOLID-STATE CIRCUITS, Bd. 27, Nr. 12, Dezember 1992 NEW YORK US, Seiten 1843-1853, XP 000329036 J. SILVA-MARTINEZ ET AL 'A 10.7-MHz 68-db SNR CMOS CONTINUOUS-TIME FILTER WITH ON-CHIP AUTOMATIC TUNING'

## Beschreibung

Die Erfindung betrifft ein abstimmbares elektronisches Filter mit einem Referenzkreis zur Regelung der Filterabstimmung.

Die charakteristischen Parameter elektronischer Filter, insbesondere integrierter elektronischer Filter weisen zum Teil erhebliche Streuungen auf. Analoge zeitkontinuierlich arbeitende elektronische Filter enthalten deshalb Transkonduktanzverstärker, deren Verstärkung einstellbar ist. Dadurch können Filterparameter abgestimmt werden. Transkonduktanzverstärker (Operational Transconductance Amplifier, OTA) sind Verstärker, z. B. Operationsverstärker, die eingangsseitig von einer Steuerspannung gesteuert werden und ausgangsseitig einen dazu proportionalen Ausgangsstrom liefern. An den Ausgang des OTA ist ein nach Bezugspotential geschalteter Kondensator angeschlossen. Aus diesem Grundelement können unter Anwendung herkömmlicher Entwurfstechniken analoge zeitkontinuierliche Filter hergestellt werden. Wird beispielsweise auf das zu filternde Eingangssignal das Ausgangssignal des OTA invertiert rückgekoppelt, ergibt sich ein gewöhnliches Tiefpaßfilter erster Ordnung.

In der US-Patentschrift 5 245 565 ist ein aus OTAs aufgebautes Besselfilter gezeigt, dessen charakteristische Frequenzen programmierbar sind. Hierzu ist ein Phasenregelkreis (PLL) mit einem VCO (spannungsgesteuerter Oszillator) vorgesehen, dem eine Referenztaktfrequenz zugeführt wird. Die jeweiligen OTAs werden durch vom PLL erzeugte Steuersignale angesteuert.

Die Verwendung eines PLL zur Steuerung der OTA-Filter ist problematisch. Üblicherweise enthält ein PLL ein Dämpfungsfilter mit einer relativ großen Zeitkonstante, um der Schwingneigung des Phasenregelkreises entgegenzuwirken. Es dauert deshalb relativ lange, bis der Phasenregelkreis eingeschwungen ist und die Eckfrequenzen des elektronischen Filters abgestimmt sind. Die Ausführung dieses Dämpfungsfilters im Phasenregelkreis würde bei einer integrierten Realisierung wegen der langen Zeitkonstante relativ viel Fläche benötigen. Darüber hinaus enthält ein Phasenregelkreis mindestens zwei Polstellen. Der Phasenregelkreis kann somit bei bestimmten Betriebsbedingungen Stabilitätsprobleme aufweisen.

In der deutschen Offenlegungsschrift DE 40 40 684 ist eine Schaltungsanordnung zur Abstimmung von RC-Filtern gezeigt, bei der die Regelspannung, mit der die Filterstufen gesteuert werden, aus einer Referenzanordnung gewonnen wird, in der die Abstimmfrequenz eines Referenzfilters mit einer vorgegebenen Sollfrequenz verglichen wird. Die Referenzschaltung enthält einen Phasendreher um 90°, dessen Ausgangssignale sowohl einen Referenzbandpaß steuert als auch einem Multiplizierer zugeführt wird, in dessen anderen Eingang der Ausgang des Referenzbandpasses eingekoppelt wird. Der Multiplizierer ist ausgangsseitig über einen Tiefpaß auf einen Integrator geführt, der die Steuerspannung für die RC-Filter erzeugt, welche wiederum in den Referenzbandpaß rückgekoppelt wird. Alternativ vorgeschlagen wird die Verwendung eines Allpasses erster Ordnung. Diese Realisierung weist jedoch aufgrund des flachen Phasenverlaufs des Allpasses erster Ordnung eine ungenaue Regelung auf.

Die Aufgabe der vorliegenden Erfindung ist es, ein einstellbares elektronisches Filter anzugeben, das mit relativ geringem schaltungstechnischem Aufwand realisierbar ist und dabei ein stabiles Betriebsverhalten aufweist.

Erfindungsgemäß wird diese Aufgabe durch ein Filter mit den Merkmalen des Patentanspruchs 1 gelöst.

Das in der Steuerungseinrichtung verwendete Allpaßfilter weist bekanntlich eine äußerst geringe Signalverzögerung auf.

Dies trifft ebenso auf den Mischer und die Verstärkereinrichtung zu. Die Einschwingzeit der Steuerungseinrichtung ist demnach relativ gering. Da keine großen Zeitkonstanten in der Steuerungseinrichtung vorliegen, können die zur Realisierung der entsprechenden Funktionselemente der Steuerungseinrichtung notwendigen Kapazitäten entsprechend klein ausgeführt werden. Der Flächenbedarf bei integrierter Realisierung des gesamten einstellbaren elektronischen Filters ist demnach relativ gering. Durch die Verwendung eines Allpaßfilters höherer Ordnung wird ein schnelles Einregeln in den eingeschwungenen Zustand erreicht. Ein Allpaß beispielsweise zweiter oder höherer Ordnung weist eine steile Phasenänderung auf, so daß die Regelung genauer und schneller erfolgt.

Vorteilhafte Weiterbildungen der Erfindung sind in den Unteransprüchen angegeben. Wenn die Zeitkonstante der Verstärkereinrichtung in diese rückgekoppelt wird, ist eine Frequenzvariation über einen weiten Einstellungsbereich möglich. Die Verwendung eines Phasenregelkreises wie im Stand der Technik würde hier erhebliche Stabilitätsprobleme aufweisen. Vorteilhafterweise wird der Verstärkereinrichtung ausgangsseitig ein nichtlineares Übertragungsglied nachgeschaltet. Zweckmäßigerweise führt dieses Übertragungsglied eine Exponentialfunktion auf sein Eingangssignal im Zeitbereich aus. Die relative Änderung des Stellsignals ist dann weitgehend unabhängig von der Referenzfrequenz. Der Einschwingvorgang läuft demnach unabhängig von der Referenzfrequenz stets gleich schnell ab. Vorzugsweise wird die Verstärkereinrichtung mit Tiefpaßcharakter durch einen Integrierer realisiert. Der Allpaß wird vorzugsweise mit einem Tiefpaß zweiter Ordnung mit hoher Güte ausgeführt. Die Filter werden jeweils aus einem OTA mit ausgangsseitigem Kondensator gebildet.

Nachfolgend wird die Erfindung anhand der in der Zeichnung dargestellten Ausführungsbeispiele näher erläutert. Es zeigen:
- Figur 1: ein einstellbares elektronisches Filter,
- Figur 2: eine Weiterbilduung des Filters nach Figur 1,
- Figur 3: ein Realisierungsbeispiel für den Allpaß und
- Figur 4: einen aus einem Transkonduktanzverstärker aufgebautem Tiefpaß erster Ordnung.

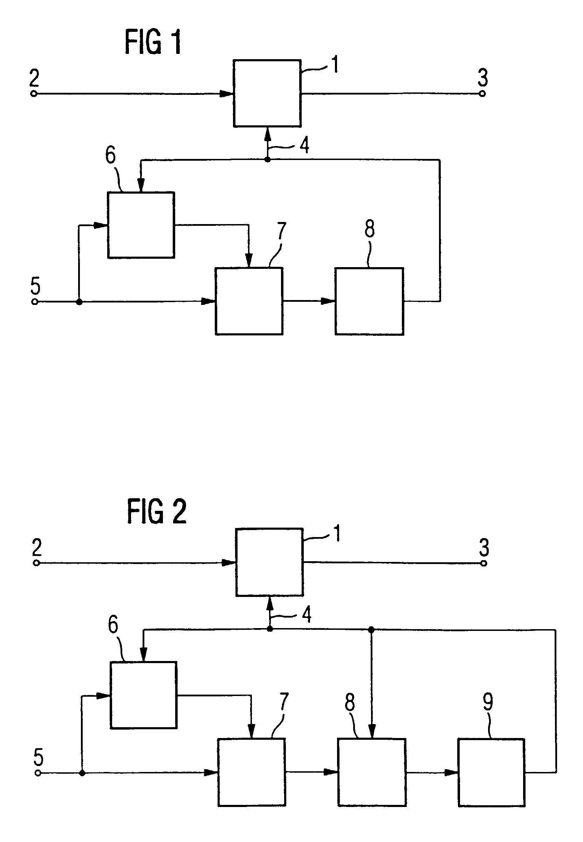

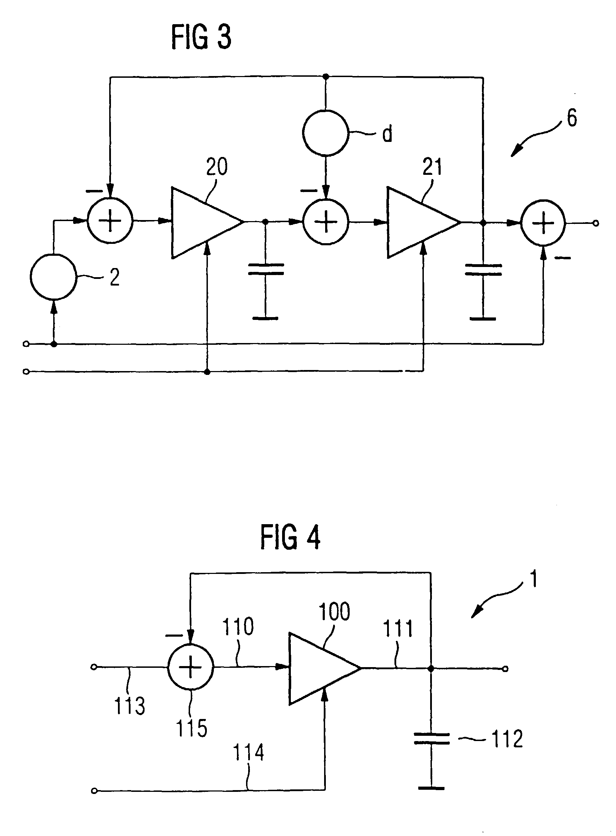

Das Filter gemäß Figur 1 enthält einen OTA mit ausgangsseitigem Kondensator 1 (OTA-C). Prinzipiell könnte als Filter 1 jegliches Filter verwendet werden, dessen charakteristische Parameter, insbesondere Eckfrequenzen, einstellbar sind. Eine beispielhafte Realisierung des Filters 1 ist in Figur 4 gezeigt. Es enthält einen Operational Transconductance Amplifier 100, an dessen Eingang 110 eine Eingangsspannung eingespeist wird. Der Verstärker 100 vergleicht diese Eingangsspannung mit einer (nicht dargestellten) Referenzspannung und wandelt diese in einen dazu proportionalen Ausgangsstrom um. Am Ausgang 111 ist ein Kondensator 112 gegen Masse geschaltet. Das Ausgangssignal ist auf den Eingang 110 rückgekoppelt, indem es von einem an einem Anschluß 113 einzuspeisenden zu filternden Eingangssignal subtrahiert wird. Über einen mit dem Verstärker 100 verbundenen Steueranschluß 114 ist der Verstärkungsfaktor des Verstärkers 100 einstellbar. Das in der Figur 4 gezeigte Filter 1 wirkt als Tiefpaß erster Ordnung. Dies entspricht einen RC-Glied mit einstellbarem Widerstand.

Dem Filter 1 (Figur 1) wird am Anschluß 2 ein zu filterndes Signal zugeführt, am Anschluß 3 liegt das gefilterte Ausgangssignal vor. Die Eckfrequenz des Tiefpaßfilters 1 ist über den Steueranschluß 4 einstellbar. Die Abstimmung wird mittels eines an einem Referenzeingang 5 eingespeisten Signals mit einer Referenzfrequenz durchgeführt. Die Referenzfrequenz kann durch äußere Schaltungsmaßnahmen, z. B. durch einen frequenzkonstanten Quarzoszillator, eingestellt werden. Die zwischen den Anschlüssen 4, 5 geschaltete Steuerungseinrichtung enthält im einzelnen ein Allpaßfilter 6, dem das Referenzfrequenzsignal vom Anschluß 5 und das Steuersignal vom Anschluß 4 zugeführt werden, einen Mischer 7, dem das Ausgangssignal des Allpasses 6 sowie das Referenzsignal vom Anschluß 5 zugeführt werden, und einen Verstärker mit Tiefpaßcharakteristik 8, der aus dem Ausgangssignal des Mischers 7 das Steuersignal 4 erzeugt. Der Verstärker mit Tiefpaßcharakteristik 8 ist vorzugsweise ein Integrierer.

Durch den Allpaß 6 wird das Referenzfrequenzsignal in Abhängigkeit von dem an seinem Steuereingang anliegenden Signalpegel in bezug auf die Phase verschoben. Am Ausgang des Mischers 7 liegt dann unter anderem ein Gleichsignal vor, dessen Pegel eine Information über die Phasendifferenz der am Mischer 7 eingespeisten Signale angibt. Durch den Integrierer 8 als Regelglied wird der vom Mischer 7 gelieferte Gleichsignalpegel ohne wesentliche Zeitverzögerung verstärkt; der im Ausgangssignal des Mischers 7 enthaltene Frequenzanteil bei der doppelten Frequenz wird unterdrückt. Durch die Einspeisung des Verstärkerausgangssignals am Steuereingang des Allpaßfilters 6 wird dieses so lange nachgestellt, bis die vom Mischer 7 gebildete Regelabweichung Null wird. Dies bedeutet, daß die dem Mischer 7 zugeführten Signale (Referenzfrequenzsignal und das über den Allpaß 6 verzögerte Referenzfrequenzsignal) eine Phasenverschiebung von 90° aufweisen. Die Eckfrequenz des Tiefpasses 1 ist dann auf denjenigen gewünschten Wert eingestellt, dem die am Anschluß 5 eingespeiste Referenzfrequenz entspricht. Ein der Eckfrequenz im Tiefpaß 1 entsprechendes Signal wird also in der aus den Elementen 6, 7, 8 gebildeten Regelschleife am Ausgang des Allpasses 6 nachgebildet. Dies setzt voraus, daß zwischen den Parametern des Tiefpasses 1 und des Allpasses 6 eine Parameterkopplung vorliegt. Bei der Realisierung als integrierte Schaltung kann dies als gegeben angenommen werden, da die relativen Genauigkeiten von Bauelementeparametern bei integrierter Realisierung auf einem Chip bekanntlich gut übereinstimmen.

Vorteilhafterweise wird auch der Allpaß 6 mittels OTA-C-Filtern realisiert. Die relative Kopplung der Bauelementeparameter der Filter 1 und 6 und somit die entsprechenden Filtercharakteristiken sind demnach bei Herstellung in einem Chip gut einstellbar und reproduzierbar. Als Allpaßfilter 6 eignet sich beispielsweise ein Tiefpaß zweiter Ordnung mit einer hohen Güte, bei dem von dessen zweifach gewichteten Ausgangssignal das Eingangssignal subtrahiert wird. Die Resonanzfrequenz des Allpasses ist durch das an seinem Steuereingang anliegenden Signal veränderbar. Als Verstärker 8 kann alternativ zu einem Integrierer auch ein gewöhnliches Tiefpaßfilter mit einer nicht verschwindenden Zeitverzögerung verwendet werden. Es wird dann auf einen konstanten, von Null verschiedenen Wert der Regelabweichung ausgeregelt.

Die in der Figur 4 gezeigte Realisierung für das OTA-C-Filter kann ohne weiteres integriert werden. Der Kondensator 112 weist eine geringe Kapazität auf, so daß der Flächenverbrauch in der integrierten Schaltung gering ist. Für den Transkonduktanzverstärker 100 und den Addierer 150 sind integrierte Transistorlösungen in vielfältigen Ausführungsformen bekannt. Entsprechendes gilt für die Einrichtungen 6, 7, 8 des abstimmbaren Filters. Das gesamte abstimmbare Filter kann demnach relativ flächengünstig realisiert werden.

Da die im Allpaßfilter 6 gebildete Phasenverschiebung ohne wesentliche Zeitverzögerung ausgeführt wird, ist der Einschwingvorgang relativ kurz, so daß eine geringe Abstimmzeit des Filters 1 auf die gewünschte Eckfrequenz vorliegt. Insgesamt zeichnet sich die Regelung durch eine gute Stabilität in allen Betriebszuständen aus.

Die Ausführung nach Figur 2 unterscheidet sich von dem in Figur 1 gezeigten abstimmbaren Filter dadurch, daß ein nichtlineares Übertragungsglied 9 vorgesehen ist, das dem Verstärker 8 ausgangsseitig nachgeschaltet ist. Darüber hinaus wird das vom Übertragungsglied 9 erzeugte Ausgangssignal auf einen entsprechenden Steuereingang des Integrierers 8 rückgekoppelt. Die Verstärkung des Integrierers 8 ist dadurch veränderbar. Insgesamt bewirkt dies, daß eine Veränderung der Eckfrequenzen des Filters 1 in einem weiten Bereich möglich ist. Das Verhältnis von minimaler zu maximaler Bereichsgrenze der Eckfrequenz des Tiefpasses 1 bzw. der am Anschluß 5 eingespeisten Referenzfrequenz kann in praktischen Ausführung ohne weiteres bei 1:20 liegen. Es hat sich auch bei einem Frequenzverhältnis von 1:100 für die untere und die obere Bereichsgrenze ein sicheres Einschwingen des Regelkreises ergeben. Eine wie im Stand der Technik vorgesehene Regelung mittels eines Phasenregelkreises würde ohne weitere Schaltungsmaßnahmen in einem solchen Fall Stabilitätsprobleme aufweisen.

Die Einrichtung 9 weist ein nichtlineares monotones Übertragungsverhalten auf, so daß das Vorzeichen des minimalen Ausgangssignals und des maximalen Ausgangssignals gleich ist. Es hat sich ein Übertragungsglied als vorteilhaft erwiesen, deren Ausgangssignal als Exponentialfunktion (e^{x}) des Eingangssignals (im Zeitbereich) gebildet wird. Ein derartiges Übertragungsglied sorgt einerseits dafür, daß das Ausgangssignal der Einrichtung 9 und somit die jeweils eingestellte Verstärkung der OTAs in den Funktionseinheiten 1, 6, 8 nicht Null wird. Das System kann dann beim Einschalten sicher anschwingen. Andererseits wird durch die Bildung der Exponentialfunktion erreicht, daß das Stellsignal am Ausgang der Einrichtung 9 beim Einregelvorgang unabhängig vom Wert der am Anschluß 5 eingespeisten Referenzfrequenz gleiche relative Änderungen ausführt. Dies liegt daran, daß die Steigung einer Exponentialfunktion proportional zu ihrem Funktionswert ist. Praktisch bedeutet dies, daß für verschiedene Referenzfrequenzen die Einschwingzeit in etwa konstant bleibt.

Eine Realisierung des Allpasses 6 als Tiefpaßfilter zweiter Ordnung mit hoher Güte ist in Figur 3 gezeigt. Im einzelnen enthält dieses zwei mit den Eingangs-Ausgangssignalpfaden in Reihe geschaltete OTA-C-Filter 20, 21. Der Ausgang des zweiten Filters 21 wird invertiert auf die jeweiligen Eingänge rückgekoppelt, wobei der Rückkopplungspfad im Fall des Filters 21 eine Dämpfung d aufweist, wobei d << 1 gilt. Das Referenzsignal wird dem ersten OTA-C-Filter 20 mit dem Verstärkungsfaktor 2 zugeführt und vom Ausgang des zweiten OTAC-Filters 21 ohne Verstärkung subtrahiert. Die beiden Steuereingänge der OTAs der Filter 20, 21 sind miteinander verbunden und werden gleichsinnig gesteuert. Der in Figur 3 gezeigte Tiefpaß zweiter Ordnung zur Realisierung des Allpasses weist vorzugsweise eine hohe Güte auf. In praktischen Fällen hat sich eine Güte Q = 10 als günstig erwiesen. Im Bereich der Resonanzfrequenz des Allpasses liegt dann idealerweise eine Phasenverschiebung von 90° vor.

## Patentansprüche

1. Abstimmbares elektronisches Filter, enthaltend:
- ein einstellbares Filter (1) mit einem Eingangsanschluß (2) zum Zuführen eines elektrischen Signals, einen Ausgangsanschluß (3) zum Abgriff eines gefilterten Signals und einen Steueranschluß (4) zum Einstellen eines charakteristischen Frequenzwerts des Filters,
- eine Steuereinrichtung, der eingangsseitig ein Signal mit einer Referenzfrequenz zuführbar ist und die ausgangsseitig mit dem Steueranschluß (4) des Filters (1) verbunden ist, wobei der Steuereinrichtung enthält:
- ein einstellbares Allpaßfilter (6) mindestens zweiter Ordnung, das einen Eingang (5) für das Referenzfrequenzsignal, einen Steuereingang zur Steuerung eines charakteristischen Frequenzwerts und einen Ausgang aufweist,
- einen Mischer (7), der einen Eingang für das Referenzfrequenzsignal und einen weiteren Eingang, der mit dem Ausgang des Allpaßfilters (6) verbunden ist, und einen Ausgang aufweist,
- eine Verstärkereinrichtung (8) mit Tiefpaßeigenschaft, die einen Eingang aufweist, der mit dem Ausgang des Mischers verbunden ist, und einen Ausgang, der mit dem Ausgang der Steuereinrichtung und mit dem Steuereingang des Allpaßfilters gekoppelt ist.

2. Abstimmbares elektronisches Filter nach Anspruch 1,
**dadurch gekennzeichnet**, daß
die Verstärkereinrichtung (8) einen Eingang zur Einstellung eines charakteristischen Frequenzparameters aufweist, auf den der Ausgang der Verstärkereinrichtung (8) rückgekoppelt ist.

3. Abstimmbares elektronisches Filter nach Anspruch 2,
**dadurch gekennzeichnet**, daß
die Verstärkereinrichtung (8) ausgangsseitig ein nichtlineares Übertragungsglied (9) aufweist, dessen Ausgangssignal nicht Null wird.

4. Abstimmbares elektronisches Filter nach Anspruch 3,
**dadurch gekennzeichnet,** daß
das mit der Verstärkereinrichtung (8) ausgangsseitig verbundene Übertragungsglied (9) eine Exponentialfunktion (e^{x}) seines Eingangssignals bildet.

5. Abstimmbares elektronisches Filter nach einem der Ansprüche 1 bis 4,
**dadurch gekennzeichnet**, daß
die Verstärkereinrichtung (8) ein Integrierer ist.

6. Abstimmbares elektronisches Filter nach einem der Ansprüche 1 bis 5,
**dadurch gekennzeichnet**, daß
das Allpaßfilter (6) aus einem Tiefpaß zweiter Ordnung gebildet ist, bei dem das Eingangssignal vom Ausgangssignal subtrahiert wird.

7. Abstimmbares elektronisches Filter nach einem der Ansprüche 1 bis 6,
**dadurch gekennzeichnet**, daß
das einstellbare Filter (1) einen Verstärker (111) mit Stromausgang (111) enthält, dessen Verstärkung über ein am Steuereingang (114) eingespeistes Signal steuerbar ist.

8. Abstimmbares elektronisches Filter nach Anspruch 7,
**dadurch gekennzeichnet**, daß
das einstellbare Filter (1) ein Tiefpaß ist, daß an den Verstärker mit Stromausgang ausgangsseitig ein mit einem Bezugspotential verbundener Kondensator (112) angeschlossen ist, daß der Eingang des Verstärkers (110) an den Ausgang eines Addierers (115) angeschlossen ist, daß dem Addierer (115) das Eingangssignal positiv und das Ausgangssignal negativ zugeführt werden.

9. Abstimmbares elektronisches Filter nach Anspruch 7 oder 8,
**dadurch gekennzeichnet**, daß
der Tiefpaß zweiter Ordnung des Allpasses (6) zwei mit ihren Eingangs-Ausgangssignalpfaden in Reihe geschaltete Verstärker (20, 21) mit Stromausgang aufweist, an deren Ausgängen jeweils ein nach Bezugspotential geschalteter Kondensator angeschlossen ist, daß dem zweiten Verstärker das invertierte Ausgangssignal des zweiten Verstärker gedämpft und dem ersten Verstärker ungedämpft zugeführt wird, daß die Referenzfrequenz dem ersten Verstärker mit verdoppelter Amplitude zugeführt wird und vom Ausgangssignal des zweiten Verstärkers subtrahiert wird und daß die Steuereingänge der Verstärker miteinander verbunden sind.

## Claims

1. Tuneable electronic filter, containing:
- an adjustable filter (1) with an input terminal (2) for feeding in an electrical signal, an output terminal (3) for picking off a filtered signal, and a control terminal (4) for setting a characteristic frequency value of the filter,
- a control device, to which a signal at a reference frequency can be fed on the input side and which is connected to the control terminal (4) of the filter (1) on the output side, the control device containing:
- an adjustable, at least second-order all-pass filter (6), which has an input (5) for the reference frequency signal, a control input for controlling a characteristic frequency value, and an output,
- a mixer (7), which has an input for the reference frequency signal and a further input, which is connected to the output of the all-pass filter (6), and an output,
- an amplifier device (8) having a low-pass filter proper.y, which has an input connected to the output of the mixer, and an output coupled to the output of the control device and to the control input of the all-pass filter.

2. Tuneable electronic filter according to Claim 1,
characterized in that
the amplifier device (8) has an input for setting a characteristic frequency parameter, to which the output of the amplifier device (8) is fed back.

3. Tuneable electronic filter according to Claim 2,
characterized in that
the amplifier device (8) has, on the output side, a non-linear transmission element (9), whose output signal does not become zero.

4. Tuneable electronic filter according to Claim 3,
characterized in that
the transmission element (9) connected to the amplifier device (8) on the output side forms an exponential function (e^{x}) of its input signal.

5. Tuneable electronic filter according to one of Claims 1 to 4,
characterized in that
the amplifier device (8) is an integrator.

6. Tuneable electronic filter according to one of Claims 1 to 5,
characterized in that
the all-pass filter (6) is formed from a second-order low-pass filter in which the input signal is subtracted from the output signal.

7. Tuneable electronic filter according to one of Claims 1 to 6,
characterized in that
the adjustable filter (1) contains an amplifier (111) with a current output (111), whose gain can be controlled by way of a signal fed in at the control input (114).

8. Tuneable electronic filter according to Claim 7,
characterized in that
the adjustable filter (1) is a low-pass filter, in that a capacitor (112) connected to a reference-earth potential is connected to the amplifier with a current output on the output side, in that the input of the amplifier (110) is connected to the output of an adder (115), in that the adder (115) has fed to it the input signal positive and the output signal negative.

9. Tuneable electronic filter according to Claim 7 or 8,
characterized in that
the second-order low-pass filter of the all-pass filter (6) has two amplifiers (20, 21) with a current output which are connected in series with their input-output signal paths and to whose outputs a respective capacitor is connected, the said capacitor being connected with respect to reference-earth potential, in that the inverted output signal of the second amplifier is fed to the second amplifier after having been attenuated, and to the first amplifier without being attenuated, in that the reference frequency is fed to the first amplifier with a doubled amplitude and is subtracted from the output signal of the second amplifier, and in that the control inputs of the amplifiers are connected to one another.

## Revendications

1. Filtre électronique accordable comprenant :
- un filtre réglable (1) comprenant une connexion d'entrée (2) pour l'introduction d'un signal électrique, une connexion de sortie (3) pour la prise d'un signal filtré et une connexion de commande (4) pour le réglage d'une valeur de fréquence caractéristique du filtre,
- un dispositif de commande auquel peut être appliqué, côté entrée, un signal ayant une fréquence de référence et qui est connecté, côté sortie, à la connexion de commande (4) du filtre (1), le dispositif de commande comprenant :
- un filtre passe-tout réglable (6) au moins du deuxième ordre, qui présente une entrée (5) pour le signal de fréquence de référence, une entrée de commande pour la commande d'une valeur de fréquence caractéristique, et une sortie,
- un mélangeur (7) qui présente une entrée pour le signal de fréquence de référence et une autre entrée qui est connectée à la sortie du filtre passe-tout (6), et une sortie,
- un dispositif amplificateur (8) ayant une propriété de passe-bas, qui présente une entrée qui est connectée à la sortie du mélangeur, et une sortie qui est couplée à la sortie du dispositif de commande et à l'entrée de commande du filtre passe-tout.

2. Filtre électronique accordable selon la revendication 1, caractérisé en ce que le dispositif amplificateur (8) présente une entrée pour le réglage d'un paramètre de fréquence caractéristique sur laquelle la sortie du dispositif amplificateur (8) est réinjectée.

3. Filtre électronique accordable selon la revendication 2, caractérisé en ce que le dispositif amplificateur (8) présente, côté sortie, un élément de transfert non linéaire (9) dont le signal de sortie ne s'annule pas.

4. Filtre électronique accordable selon la revendication 3, caractérisé en ce que l'élément de transfert (9) connecté côté sortie au dispositif amplificateur (8) forme une fonction exponentielle (e^{x}) de son signal d'entrée.

5. Filtre électronique accordable selon une des revendications 1 à 4, caractérisé en ce que le dispositif amplificateur (8) est un intégrateur.

6. Filtre électronique accordable selon une des revendications 1 à 5, caractérisé en ce que le filtre passe-tout (6) est formé à partir d'un filtre passe-bas de deuxième ordre, dans lequel le signal d'entrée est soustrait du signal de sortie.

7. Filtre électronique accordable selon une des revendications 1 à 6, caractérisé en ce que le filtre réglable (1) comprend un amplificateur (111) ayant une sortie de courant (111) dont l'amplification peut être commandée par un signal appliqué à l'entrée de commande (114).

8. Filtre électronique accordable selon la revendication 7, caractérisé en ce que le filtre réglable (1) est un passe-bas, en ce qu'à l'amplificateur possédant une sortie de courant, est connecté, côté sortie, un condensateur (112) connecté à un potentiel de référence, en ce que l'entrée de l'amplificateur (110) est connectée à la sortie d'un additionneur (115), en ce qu'à l'additionneur (115) sont appliqués, en positif, le signal d'entrée et, en négatif, le signal de sortie .

9. Filtre électronique accordable selon la revendication 7 ou 8, caractérisé en ce que le passe-bas de deuxième ordre du passe-tout (6) comprend deux amplificateurs (20, 21) à sortie de courant, connectés en série avec leur trajet de signal entrée-sortie, à la sortie de chacun desquels est connecté un condensateur lui même branché d'après le potentie' de référence, en ce que le signal de sortie inversé du deuxième amplificateur est appliqué au deuxième amplificateur à l'état amorti et est appliqué au premier amplificateur à l'état non amorti, en ce que la fréquence de référence est transmise au premier amplificateur avec un amplitude doublée et est soustraite du signal de sortie du deuxième amplificateur et en ce que les entrées de commande des amplificateurs sont connectées entre elles.
